# EUROPEAN PATENT APPLICATION

(11) **EP 4 704 526 A1**
(43) Date of publication of application: **04.03.2026**
(21) Application number: 25157317.6
(22) Date of filing: 12.02.2025
(51) Int. Cl.: H10F 71/00, H10F 77/20, H10F 77/30

(54) **BACK-CONTACT CELL AND PREPARATION METHOD THEREOF AND BACK-CONTACT CELL MODULE**

(30) Priority: 26.08.2024 CN 202411171714
(71) Applicant: Trina Solar Co., Ltd, Changzhou, Jiangsu 213031 (CN)
(72) Inventor: LIU, Wei, Changzhou, 213031 (CN); LIU, Zhiyuan, Changzhou, 213031 (CN); CHEN, Daming, Changzhou, 213031 (CN)
(74) Representative: Nederlandsch Octrooibureau

(57) **Abstract**

The present application provides a back-contact cell, a method for preparing the same, and a back-contact cell module. The back-contact cell includes: a silicon substrate, wherein the silicon substrate includes a substrate front side close to sunlight and a substrate back side away from sunlight; a first doping region, an isolation region, and a second doping region, located on the substrate back side, wherein the first doping region and the second doping region have different doping elements, and the isolation region is located between the first doping region and the second doping region on the substrate back side; a front passivation anti-reflection layer located on the substrate front side; and a protective layer located on at least part of the front passivation anti-reflection layer, wherein the protective layer includes resin material. The back-contact cell, the method for preparing the same, and the back-contact cell module of the present application can eliminate the isolation paper between cells, reduce the production cost, and improve the production yield of photovoltaic cells.

## Description

### Technical Field

The present application mainly relates to the field of photovoltaic technology, and in particular to a back-contact cell and a preparation method thereof, as well as a back-contact cell module.

### Background

Back-contact photovoltaic cell (IBC, Interdigitated back-contact) has both a P region and an N region on the back side of the cell. In this design, electronhole pairs are generated in the high-life body region and collected in the N and P regions on the back of the cell. The metal on the back side of the cell connects the P region and the N region through P-type metal contacts and N-type metal contacts respectively, and there is no metal pattern on the front side, thereby avoiding light blocking and improving light absorption. The cell types derived on this basis have relatively better effects. For example, the TBC cell efficiency after combining the TOPCon (Tunnel Oxide Passivated Contact) cell with the IBC cell is higher than the traditional TOPCon cell.

For conventional double-sided metallized cells, the height of the metal electrode is higher than the surface of the passivation film, so the cells can be stacked directly without rubbing against the passivation film, which would cause problems such as poor EL performance. However, since there is no grid line on the front side of the back-contact cell (IBC) to protect the front passivation film, the cells cannot be stacked directly. The existing method requires placing isolation paper directly between the two cells to protect the front suede surface. However, isolation paper not only increases manufacturing costs, but also easily causes problems such as scratches on the cell and equipment failure during transportation.

### Brief Summary

The technical problem to be solved by the present application is to provide a back-contact cell and a preparation method thereof, as well as a back-contact cell module, which can save the isolation paper between cells, reduce the production cost, and improve the yield of photovoltaic cell preparation.

To solve the above technical problems, the present application provides a back-contact cell, comprising: a silicon substrate, wherein the silicon substrate comprises a substrate front side close to sunlight and a substrate back side away from the sunlight; a first doping region, an isolation region, and a second doping region, located on the substrate back side, wherein the first doping region and the second doping region have different doping elements, and the isolation region is located between the first doping region and the second doping region on the substrate back side; a front passivation anti-reflection layer, located on the substrate front side; and a protective layer, located on at least part of the front passivation anti-reflection layer, wherein the protective layer comprises resin material.

Optionally, the back-contact cell further includes a cell edge and an edge protection area, wherein the protection layer is located in the edge protection area, and the outer side of the edge protection area closer to the cell edge is between 0.1 mm and 10 mm away from the cell edge.

Optionally, the width of the edge protection area is 0.005mm ~10mm.

Optionally, the protective layer has a pyramid texture.

Optionally, the protective layer is formed by roller embossing, wherein the roller surface has pyramid-shaped protrusions.

Optionally, the protective layer is formed by attaching a protective agent on at least a portion of the front passivation anti-reflection layer, performing a first curing, using roller embossing, and performing a second curing, wherein a first curing time of the first curing is shorter than a second curing time of the second curing.

Optionally, the irradiation energy of the first curing and /or the second curing is 1300 mj/cm²-1700 mj/cm².

Optionally, the protective layer is formed by spraying a protective agent, wherein the spray printing includes spraying the protective agent in the shape of ink drops on at least a portion of the front passivation anti-reflection layer to form a protective layer having the pyramid texture on the front passivation anti-reflection layer.

Optionally, the protective layer is formed by screen printing a protective agent, wherein the screen printing screen mold has a pyramid shape, and the screen printing includes printing the protective agent on at least a portion of the front passivation anti-reflection layer through the screen mold to form a protective layer having the pyramid texture on the front passivation anti-reflection layer.

Optionally, the silicon substrate is an N-type substrate or a P-type substrate.

Optionally, the substrate front side is a suede surface, and the side of the front passivation anti-reflection layer away from the substrate front side is also the suede surface.

Optionally, the front passivation anti-reflection layer includes aluminum oxide, silicon nitride and /or silicon oxynitride.

Optionally, the back-contact cell further includes a back passivation anti-reflection layer located on a side of the first doping region, the isolation region and the second doping region away from the substrate back side, and the back passivation anti-reflection layer includes aluminum oxide and /or silicon nitride.

Optionally, the back-contact cell further includes a first electrode and a second electrode, which pass through the back passivation anti-reflection layer on one side of the substrate back side and are in contact with the first doping region and the second doping region respectively.

Optionally, the protective layer covers 1% to 50% of the substrate front side.

Optionally, the protective layer is in a continuous or discontinuous straight-line shape, or an irregular shape on the substrate front side of the back-contact cell.

Optionally, the thickness of the protective layer along a first direction perpendicular to the silicon substrate is 6 microns to 15 microns.

Optionally, the protective layer has a transmittance greater than 80% for incident light in the wavelength range of 300 nm to 1200 nm.

Optionally, the refractive index of the protective layer is less than 1.6.

Optionally, the resin material includes epoxy resin or acrylic resin.

In order to achieve the above-mentioned purpose, another aspect of the present application further proposes a method for preparing a back-contact cell, comprising the following steps: preparing a silicon substrate, wherein the silicon substrate comprises a substrate front side close to sunlight and a substrate back side away from the sunlight; preparing a first doping region, an isolation region, and a second doping region on the substrate back side, wherein the first doping region and the second doping region have different doping elements, and the isolation region is located between the first doping region and the second doping region on the substrate back side; preparing a front passivation anti-reflection layer on the substrate front side; and preparing a protective layer on at least a portion of the front passivation anti-reflection layer, wherein the protective layer comprises resin material.

Optionally, the back-contact cell has a cell edge, and the step of preparing the protective layer includes preparing the protective layer in an edge protection area, wherein the outer side of the edge protection area closer to the cell edge is between 0.1 mm and 10 mm away from the cell edge.

Optionally, the step of preparing the protective layer includes preparing a protective layer having a pyramid texture.

Optionally, the step of preparing the protective layer includes: spraying a protective agent on at least a portion of the front passivation anti-reflection layer and performing a first curing; imprinting the protective agent with a roller having pyramid-shaped protrusions so that the protective agent presents a pyramid morphology; and performing a second curing.

Optionally, the first curing time is 2s~4s, and /or the second curing time is 4s~8s, and /or the irradiation energy range of the first curing and the second curing is 1300mj/cm²-1700mj/cm².

Optionally, the step of preparing the protective layer includes: spraying a protective agent on at least a portion of the front passivation anti-reflection layer, while controlling the protective agent to be in the shape of ink drops so that the protective agent presents a pyramid morphology when attached to the front passivation anti-reflection layer; and performing photocuring.

Optionally, the step of preparing the protective layer includes: preparing a screen mold with pyramid protrusions; printing a protective agent on at least a portion of the front passivation anti-reflection layer through the screen mold so that the protective agent presents a pyramid morphology when attached to the front passivation anti-reflection layer; and performing photocuring.

Optionally, the preparation method also includes: polishing the silicon substrate during preparation of the silicon substrate; preparing the first doping region by LPCVD and boron diffusion; using a laser to remove a borosilicate glass in a partial area of the substrate back side; cleaning and removing the first doping region in the partial area of the substrate back side, and performing phosphorus diffusion to prepare the second doping region; cleaning and removing the borosilicate glass and/or phosphosilicate glass on the substrate front side and/or the side of the substrate, and performing texturing on a side of the substrate front side; preparing double-sided aluminum oxide, and preparing the front passivation anti-reflection layer on the substrate front side; preparing a first electrode and a second electrode on a side of the substrate back side; and preparing the protective layer on at least a portion of the front passivation anti-reflection layer.

Another aspect of the present application also proposes a back-contact cell module, including a plurality of back-contact cells proposed in any embodiment of the present application stacked on each other, or a plurality of back-contact cells and made by the preparation method proposed in any embodiment of the present application stacked on each other.

Compared with the existing technology, this application has the following advantages. Back-contact cell proposed in the present application, by providing a protective layer comprising a resin material on the passivation anti-reflection layer on the front side of the cell, not only protects the back-contact cell itself, but also eliminates the need for additional isolation paper when multiple back-contact cells are in contact or stacked, which can reduce costs and improve yields in the manufacturing process and subsequent processing and application processes of the back-contact cell. On this basis, in some preferred embodiments, the protective layer has a pyramid texture, so that the reflection of incident light by the protective layer can be further reduced for the back-contact cell itself. On the other hand, in some preferred embodiments, the protective layer is provided at the edge of the cell, which more effectively protects the edge of the cell, avoids scratches on the functional layers (such as the passivation layer) inside the cell caused by scratches on the edge of the cell, and further improves the yield of cell generation.

### Brief Description of the Drawings

The accompanying drawings are included to provide a further understanding of the present application. They are included and constitute a part of the present application. The accompanying drawings illustrate embodiments of the present application and together with the present specification serve to explain the principles of the present application. In the accompanying drawings:
FIG. 1 is a schematic structural diagram of a back-contact cell according to an embodiment of the present application;
FIG. 2 and FIG. 3 are schematic diagrams showing the arrangement of a protective layer in a back-contact cell in different embodiments of the present application;
FIG. 4, FIG. 5 and FIG. 6 are schematic diagrams of the arrangement positions of a protective layer in a back-contact cell in different embodiments of the present application;
FIG. 7 is a schematic diagram showing the principle of enhancing the reflection effect of a protective layer in a back-contact cell according to an embodiment of the present application; and
FIG. 8 and FIG. 9 are schematic flow charts of a method for preparing a back-contact cell according to different embodiments of the present application.

### Detailed Description

In order to more clearly illustrate the technical solutions of the embodiments of the present application, the following is a brief introduction to the drawings required for the description of the embodiments. Obviously, the drawings described below are only some examples or embodiments of the present application. For ordinary technicians in this field, the present application can also be applied to other similar scenarios based on these drawings without creative work. Unless it is obvious from the language environment or otherwise explained, the same reference numerals in the figures represent the same structure or operation.

As shown in this application and claims, unless the context clearly indicates an exception, the words "a", "an", "an" and/or "the" do not refer to the singular and may also include the plural. Generally speaking, the terms "comprises" and "includes" only indicate the inclusion of the steps and elements that have been clearly identified, and these steps and elements do not constitute an exclusive list. The method or device may also include other steps or elements.

Unless otherwise specifically stated, the relative arrangement, numerical expressions and numerical values of the parts and steps set forth in these embodiments do not limit the scope of the present application. At the same time, it should be understood that, for ease of description, the sizes of the various parts shown in the accompanying drawings are not drawn according to the actual proportional relationship. The technology, method and equipment known to those of ordinary skill in the relevant art may not be discussed in detail, but in appropriate cases, the technology, method and equipment should be considered as a part of the authorization specification. In all examples shown and discussed here, any specific value should be interpreted as being merely exemplary, rather than as a limitation. Therefore, other examples of exemplary embodiments may have different values. It should be noted that similar reference numerals and letters represent similar items in the following drawings, and therefore, once a certain item is defined in an accompanying drawing, it does not need to be further discussed in subsequent drawings.

In the description of the present application, it should be understood that the directions or positional relationships indicated by directional words such as "front, back, up, down, left, right", "lateral, vertical, perpendicular, horizontal" and "top, bottom" are usually based on the directions or positional relationships shown in the drawings, and are only for the convenience of describing the present application and simplifying the description. Unless otherwise specified, these directional words do not indicate or imply that the device or element referred to must have a specific direction or be constructed and operated in a specific direction, and therefore cannot be understood as limiting the scope of protection of the present application; the directional words "inside and outside" refer to the inside and outside relative to the contours of each component itself.

For ease of description, spatially relative terms such as "above", "above", "on the upper surface of", "above", etc. may be used here to describe the spatial positional relationship between a device or feature and other devices or features as shown in the figure. It should be understood that spatially relative terms are intended to include different orientations of the device in use or operation in addition to the orientation described in the figure. For example, if the device in the accompanying drawings is inverted, the device described as "above other devices or structures" or "above other devices or structures" will be positioned as "below other devices or structures" or "below other devices or structures". Thus, the exemplary term "above" can include both "above" and "below". The device can also be positioned in other different ways (rotated 90 degrees or in other orientations), and the spatially relative descriptions used here are interpreted accordingly.

In addition, it should be noted that the use of words such as "first" and "second" to define components is only for the convenience of distinguishing the corresponding components. If not otherwise stated, the above words have no special meaning and cannot be understood as limiting the scope of protection of this application. In addition, although the terms used in this application are selected from well-known and commonly used terms, some terms mentioned in the specification of this application may be selected by the applicant at his or her discretion, and their detailed meanings are explained in the relevant parts of the description of this article. In addition, it is required to understand this application not only by the actual terms used, but also by the meaning implied by each term.

It should be understood that when a component is referred to as being "on another component," "connected to another component," "coupled to another component," or "contacting another component," it may be directly on, connected to, coupled to, or contacting the other component, or there may be intervening components. In contrast, when a component is referred to as being "directly on another component," "directly connected to," "directly coupled to," or "directly contacting" another component, there are no intervening components. Similarly, when a first component is referred to as being "electrically in contact with" or "electrically coupled to" a second component, there is an electrical path between the first component and the second component that allows current to flow. The electrical path may include capacitors, coupled inductors, and/or other components that allow current to flow, even without direct contact between conductive components.

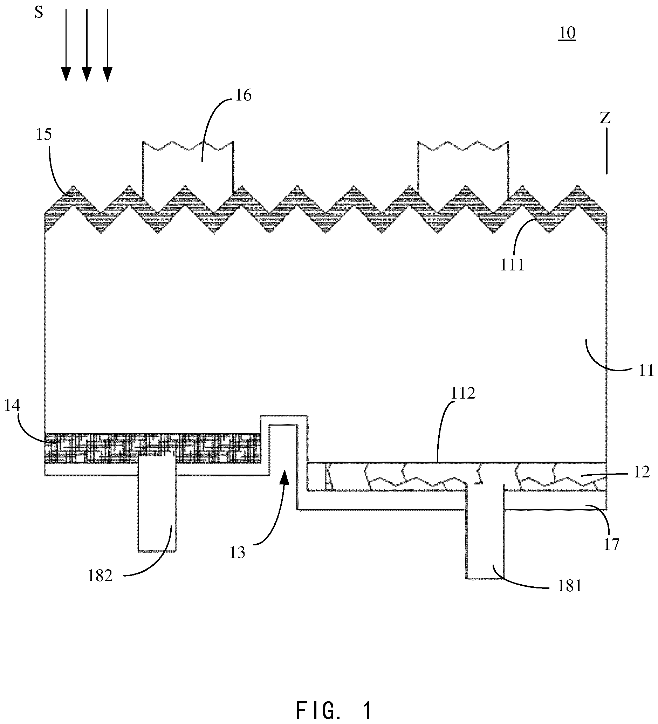

An embodiment of the present application proposes a back-contact cell 10 with reference to FIG. 1, comprising a silicon substrate 11, a first doping region 12, an isolation region 13, a second doping region 14, a front passivation anti-reflection layer 15, and a protective layer 16. Specifically, the silicon substrate 11 comprises a substrate front side 111 close to the sunlight S and a substrate back side 112 away from the sunlight. The first doping region 12, the isolation region 13, and the second doping region 14 are located on the substrate back side 112, wherein the first doping region 12 and the second doping region 14 have different doping elements, and the isolation region 13 is located between the first doping region 12 and the second doping region 14 on the substrate back side 112. The front passivation anti-reflection layer 15 is located on the substrate front side 111. The protective layer 16 is located on at least part of the front passivation anti-reflection layer 15. In the present application, the protective layer 16 comprises resin material. Preferably, the resin material may be an epoxy resin or an acrylic resin.

For example, in different embodiments of the present application, the silicon substrate 11 may be an N-type substrate doped with phosphorus or a P-type substrate doped with boron. In the embodiment shown in FIG.1, preferably, the front surface 111 of the substrate is a suede surface, and the side of the front passivation anti-reflection layer 15 away from the front surface 111 of the substrate also presents a suede surface morphology. In the embodiment, the substrate back side 112 of the back-contact cell 10 is specifically implemented as a polished surface, but the present application is not limited thereto.

In the embodiment shown in FIG. 1, the front passivation anti-reflection layer 15 comprises aluminum oxide, silicon nitride and/or silicon oxynitride. Further preferably, in this embodiment, the back-contact cell 10 further comprises a back passivation anti-reflection layer 17, which is located on the side of the first doping region 12, the isolation region 13 and the second doping region 14 away from the substrate back side 112, and the back passivation anti-reflection layer 17 comprises aluminum oxide and/or silicon nitride. On this basis, FIG. 1 further shows that the back-contact cell 10 comprises a first electrode 181 and a second electrode 182, which pass through the back passivation anti-reflection layer 17 on one side of the substrate back side 112 and are in contact with the first doping region 12 and the second doping region 14 respectively.

In this embodiment, by providing the protective layer 16, when the back-contact cells 10 need to be stacked with each other in various situations such as during the preparation process or even in the subsequent component formation process, there is no need to provide additional isolation paper between adjacent cells to avoid the destruction of the suede structure of the back-contact cell 10 facing the sunlight S, thereby reducing costs and improving yields. Preferably, for the entire back-contact cell 10, the protective layer 16 covers 1% to 50% of the substrate front surface 111. By such a setting, while protecting the back-contact cell 10, the shielding of the sunlight S can be minimized, thereby reducing the impact on the cell efficiency. Therefore, within the range of 1% to 50%, it is preferably set to a coverage ratio of 8 % to 15%, or more preferably, 10 % or a range of 9 % to 11% can be selected.

Further preferably, in order to take into account the role of the protective layer 16 and to avoid blocking the sunlight S as much as possible, the protective layer 16 can also be preferably selected for other characteristics such as size. Exemplarily, the protective layer 16 can be set to a thickness of less than 100 microns along the first direction Z perpendicular to the silicon substrate 11, preferably 10 microns or in the range of about 10 microns, for example, it is preferably set to 6 microns to 15 microns. Further preferably, when selecting and setting the material of the protective layer 16, it can be controlled to have a transmittance of more than 80% for the incident light in the band of 300 nanometers to 1200 nanometers. On this basis, on the other hand, the refractive index of the protective layer 16 is less than 1.6, preferably in the range of 1.2 to 1.6. It should be noted that the present application does not make necessary restrictions on the thickness, material, etc. of the above-mentioned protective layer 16. In different implementation situations, the relationship between transmittance, refractive index or thickness can be comprehensively considered. For example, when the protective layer 16 adopts a material with a higher transmittance, the thickness of the protective layer 16 can be appropriately increased, thereby playing a better protective role. For the back-contact cell 10, according to the actual production situation, it is considered that the protective layer 16 is set to have a thickness of 6 microns to 15 microns along the first direction Z perpendicular to the silicon substrate 11, and the transmittance of the incident light in the band of 300 nanometers to 1200 nanometers is greater than 80% and/or the refractive index is within the range of 1.2 to 1.6 as a more preferred characteristic selection.

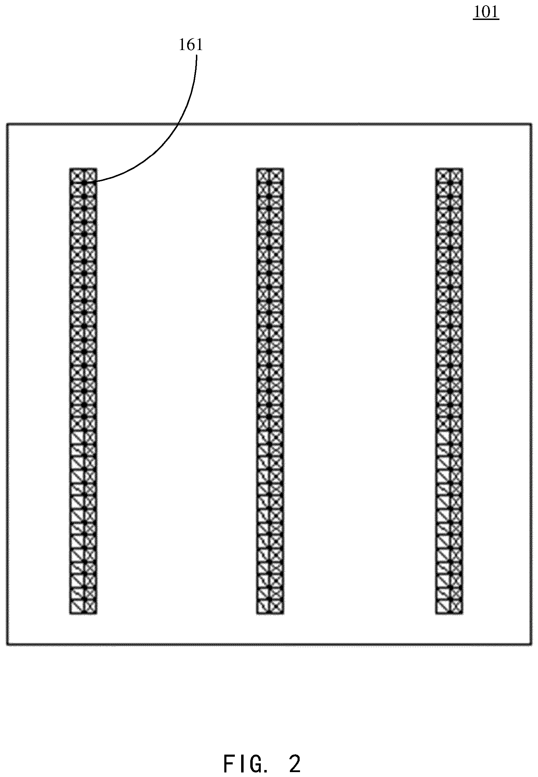

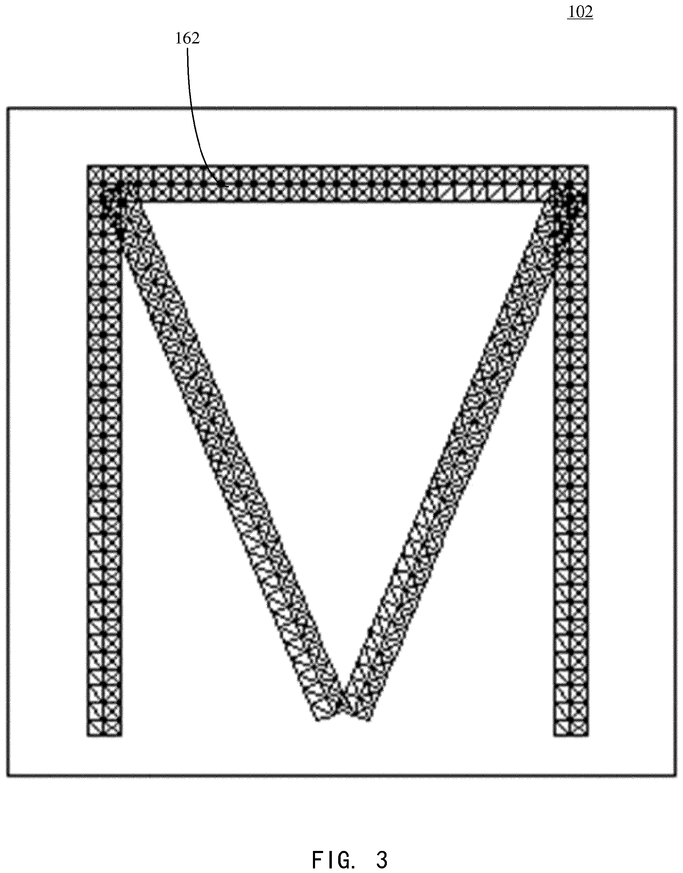

It is understandable that, since the role of the protective layer 16 is to protect the back-contact cell 10, the present application does not limit the specific position of the protective layer 16 on the back-contact cell 10 and the final arrangement thereof. For example, on the side of the substrate front side 111, the protective layer 16 can be in a continuous or discontinuous straight-line shape, or an irregular shape (such as a dot shape). In addition, the protective layer 16 does not necessarily need to correspond to the position of the first electrodes 181 and 182 on the substrate back side 112, etc. (FIG. 1 only provides a schematic diagram of the position). Exemplarily, FIG. 2 and FIG. 3 show two different implementations based on the embodiment of FIG. 1, respectively showing a back-contact cell 101 and a back-contact cell 102, wherein, except for the different arrangement of the protective layer, the other structures of the back-contact cell 101 and the back-contact cell 102 are the same as the back-contact cell 10 shown in FIG. 1. According to FIG. 2, the protective layer 161 in the back-contact cell 101 is arranged as three continuous straight-lines, and according to FIG. 3, the protective layer 162 of the back-contact cell 102 is arranged as a continuous straight-line that takes into account both the edge area and the middle area. It should be noted that FIG. 2 and FIG. 3 only exemplarily show some arrangements of the protective layer, but the present application is not limited thereto. Among these arrangements, it can be considered that there are some preferred options, such as, with reference to FIG. 2, setting the protective layer 1 61 to a structure that is roughly centrally symmetrical relative to the entire back-contact cell 101, and so on. Those skilled in the art can make specific selections and arrangements according to actual conditions.

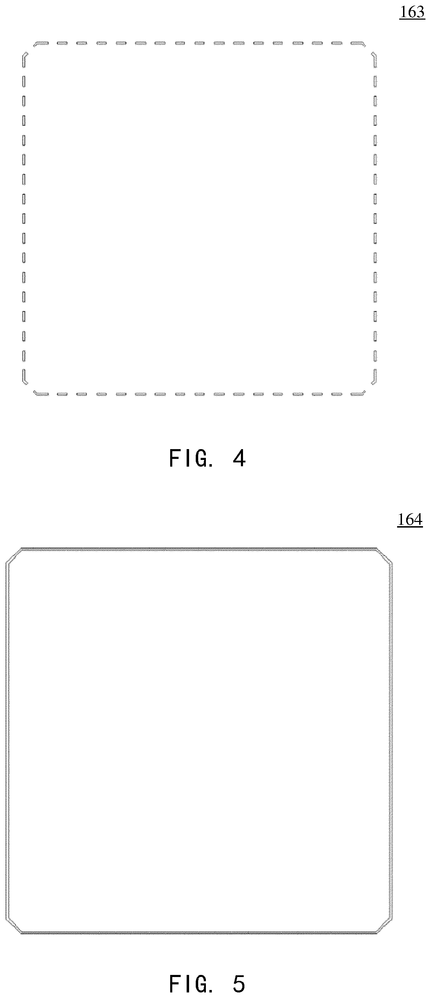

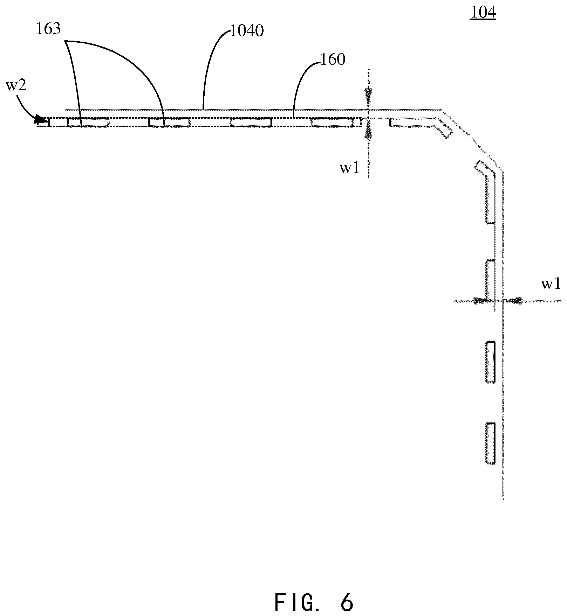

On this basis, the present application also proposes a preferred implementation method in combination with FIGs. 4 to 6, wherein FIG. 4 and FIG. 5 respectively propose two preferred implementation methods for the protective layer (protective layer 163 and protective layer 164, respectively), and FIG. 6 shows a partial schematic diagram of the protective layer 163 shown in FIG. 4 formed on the back-contact cell 104. First, referring to FIG. 6, in such a preferred embodiment, the back-contact cell 104 includes a cell edge 1040 and an edge protection area 160, the protective layer 163 is located in the edge protection area 160, and the outer side of the edge protection area 160 closer to the cell edge 1040 has a distance w1 with a value ranging from 0.1 mm to 10 mm from the cell edge 1040.

It is understandable that, for the sake of simplicity of the drawings, a portion of the edge protection area 160 is shown in FIG. 6 using a dotted line. It can be considered that all the intermittently arranged protective layers 163 shown in FIG. 6 are connected as a whole in the extension manner indicated by the dotted line frame to form a complete edge protection area 160. Further preferably, the value of the width w2 of the edge protection area 160 can be set to 0.005 mm to 10 mm. Combined with FIG. 4 and FIG. 5, FIG. 4 shows the overall morphology of the protective layer 163 arranged along the complete cell edge 1040 in the embodiment of FIG. 6, and presents a discontinuous structure similar to a rectangle, while in contrast, FIG. 5 shows the protective layer 164, and the discontinuous structure is adjusted to a continuous structure based on the protective layer 163. Similar to the above description, even if the protective layer is arranged at a position close to the cell edge to implement the preferred embodiment, the present application does not limit the specific implementation of the protective layer as continuous, discontinuous or regular pattern, special shape, etc.

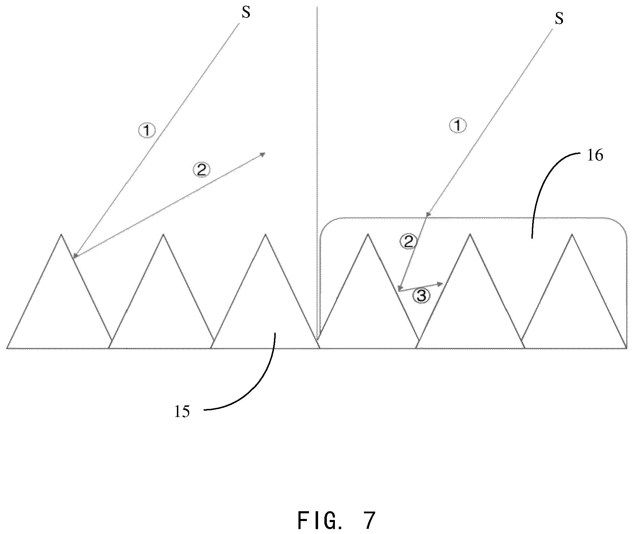

In the embodiment shown in FIG. 1, since a protective layer 16 is provided on the front passivation anti-reflection layer 15 of the back-contact cell 10, the absorption probability of the incident light can be increased. Specifically, referring to FIG. 7, the left part of FIG. 7 is the area on the surface of the back-contact cell 10 where the protective layer 16 is not provided, and the right part of FIG. 7 shows the area on the surface of the back-contact cell 10 where the protective layer 16 is provided. It can be seen that after the protective layer 16 is provided on the front passivation anti-reflection layer 15, some of the sunlight S that passes through the first path and then directly reflects through the second path generates a third path through the refraction of the protective layer 16 and is retained in the back-contact cell 10.

On this basis, it is more preferred that, for example, in the embodiment shown in FIG. 1, part or all of the protective layer 16 can also be set as a pyramid texture, so as to further enhance the anti-reflection effect of the side of the back-contact cell 10 facing the sunlight S. In the present application, the protective layer 16 with a pyramid texture can be prepared by a variety of processes, and the following is a more preferred case. In the first case, the protective layer 16 can be formed by roller embossing, wherein the surface of the roller has a pyramid-shaped protrusion. Specifically, the protective layer 16 is formed by attaching a protective agent to at least part of the front passivation anti-reflection layer 15, curing it for the first time, using roller embossing, and curing it for the second time, wherein the first curing time of the first curing is shorter than the second curing time of the second curing. In this way, after the protective agent is attached to the front passivation anti-reflection layer 15, it is not completely cured, so that the roller with a pyramid-shaped protrusion on the surface can form the morphology of the pyramid texture of the initially shaped protective agent by embossing. Preferably, the irradiation energy of the first curing and/or the second curing is in the range of 1300mj/cm² to 1700mj/cm² for better curing effect, and can be preferably set to 1500mj/cm² or values close thereto.

Alternatively, in some other scenarios, the protective layer 16 can also be formed by spraying a protective agent, wherein the spray printing includes spraying a protective agent in the shape of ink drops on at least a portion of the front passivation anti-reflection layer 15 to form a protective layer 16 having a pyramid texture on the front passivation anti-reflection layer 15. Specifically, by directly spraying the protective agent, the protective agent in the shape of ink drops can be directly formed on the front passivation anti-reflection layer 15, and after one-time curing, a protective layer 16 with a pyramid texture morphology is formed.

On the other hand, the protective layer 16 can also be formed by screen printing a protective agent, wherein the screen printing screen mold has a pyramid shape. The screen printing step includes printing the protective agent on at least part of the front passivation anti-reflection layer 15 through the screen mold to form a protective layer 16 with a pyramid texture on the front passivation anti-reflection layer 15.

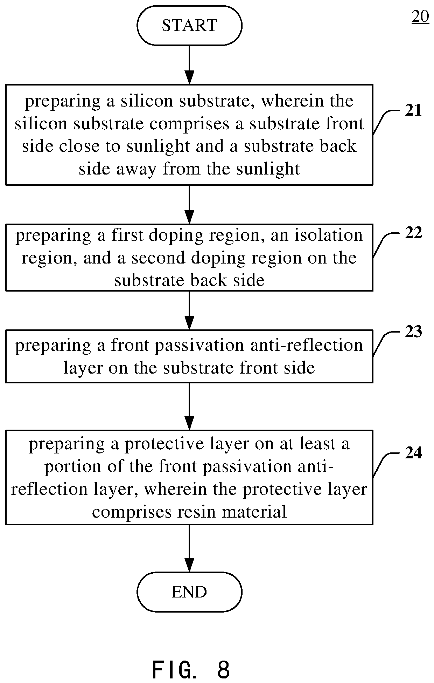

The present application proposes a method 20 for preparing a back-contact cell (hereinafter referred to as "preparation method 20 ") with reference to FIG. 8. According to FIG. 8, the preparation method 20 includes the following steps:
Step 21 is preparing a silicon substrate, wherein the silicon substrate comprises a substrate front side close to sunlight and a substrate back side away from the sunlight. Step 22 is preparing a first doping region, an isolation region, and a second doping region on the substrate back side, wherein the first doping region and the second doping region have different doping elements, and the isolation region is located between the first doping region and the second doping region on the substrate back side. Step 23 is preparing a front passivation anti-reflection layer on the substrate front side. Step 24 is preparing a protective layer on at least part of the front passivation anti-reflection layer, wherein the protective layer comprises resin material.

In some embodiments, preferably, the back-contact cell prepared by preparation method 20 has a cell edge, and step 24 of preparing the protective layer includes preparing a protective layer in an edge protection area, and the outer side of the edge protection area closer to the cell edge is between 0.1 mm and 10 mm away from the cell edge.

On the other hand, preferably, step 24 of preparing the protective layer includes preparing a protective layer having a pyramid texture. Specifically, step 24 of preparing the protective layer can be performed by different replaceable preparation process means. Three preferred embodiments are listed below.

First, step 24 of preparing the protective layer can be achieved by: spraying a protective agent on at least part of the front passivation anti-reflection layer, and performing a first curing; embossing the protective agent with a roller having pyramid-shaped protrusions so that the protective agent presents a pyramid texture; and performing a second curing. Preferably, the time of the first curing is 2s to 4s, and/or the time of the second curing is 4s to 8s, and/or the irradiation energy range of the first curing and the second curing is 1300mj/cm² to 1700mj/cm². Exemplarily, the irradiation energy of the first curing and the second curing can be set to be the same or similar.

Second, step 24 of preparing the protective layer can be achieved by: spraying a protective agent on at least part of the front passivation anti-reflection layer, while controlling the protective agent to be in the shape of ink drops so that the protective agent presents a pyramid texture when attached to the front passivation anti-reflection layer; and performing light curing.

Third, step 24 of preparing the protective layer can also be achieved by: preparing a screen mold with pyramid protrusions; printing a protective agent on at least part of the front passivation anti-reflection layer through the screen mold so that the protective agent presents a pyramid texture when attached to the front passivation anti-reflection layer; and performing light curing.

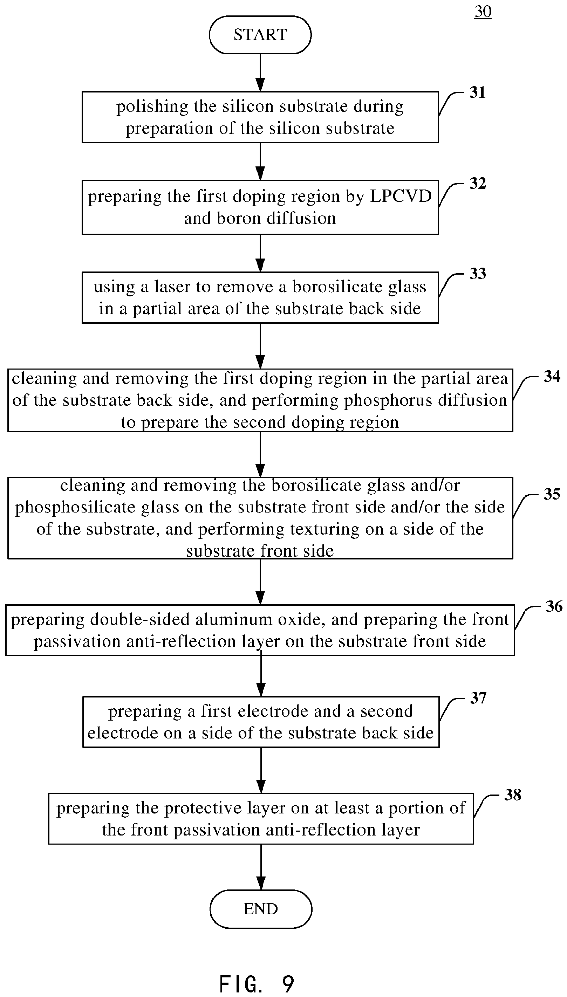

No matter which of the above methods is used, a protective layer with a pyramid texture can be formed in the back-contact cell, thereby further improving the anti-reflection effect of the back-contact cell surface on incident light. More specifically, FIG. 9 shows a specific implementation method based on the preparation method 20 shown in FIG. 8, that is, a preparation method 30 of a back-contact cell (hereinafter referred to as "preparation method 30 "). According to FIG. 9, the preparation method 30 includes the following steps:
Step 31 is polishing the silicon substrate during preparation of the silicon substrate;
Step 32 is preparing the first doping region by LPCVD and boron diffusion;
Step 33 is using a laser to remove a borosilicate glass in a partial area of the substrate back side;
Step 34 is cleaning and removing the first doping region in the partial area of the substrate back side, and performing phosphorus diffusion to prepare the second doping region;
Step 35 is cleaning and removing the borosilicate glass and/or phosphosilicate glass on the substrate front side and/or the side of the substrate, and performing texturing on a side of the substrate front side;
Step 36 is preparing double-sided aluminum oxide, and preparing the front passivation anti-reflection layer on the substrate front side;
Step 37 is preparing a first electrode and a second electrode on a side of the substrate back side; and
Step 38 is preparing the protective layer on at least a portion of the front passivation anti-reflection layer.

Preparation method 30 is a specific implementation method based on preparation method 20, but the present application is not limited thereto. In addition, since preparation method 20 and preparation method 30 can be used to prepare the back-contact cell shown in FIG. 1, other details about preparation method 20 and preparation method 30 can also refer to the previous description, which will not be repeated here.

It should be noted that in the present application, FIG. 8 and FIG. 9 use flow charts to illustrate the operations performed by the system according to the embodiments of the present application. It should be understood that the preceding or following operations are not necessarily performed precisely in order. On the contrary, various steps may be processed in reverse order or simultaneously. At the same time, other operations may be added to these processes, or one or more operations may be removed from these processes.

The basic concepts have been described above. Obviously, for those skilled in the art, the above application disclosure is only an example and does not constitute a limitation of the present application. Although not explicitly stated herein, those skilled in the art may make various modifications, improvements and corrections to the present application. Such modifications, improvements and corrections are suggested in the present application, so such modifications, improvements and corrections still belong to the spirit and scope of the exemplary embodiments of the present application.

At the same time, the present application uses specific words to describe the embodiments of the present application. For example, "one embodiment", "an embodiment", and/or "some embodiments" refer to a certain feature, structure or characteristic related to at least one embodiment of the present application. Therefore, it should be emphasized and noted that "one embodiment" or "an embodiment" or "an alternative embodiment" mentioned twice or more in different positions in this specification does not necessarily refer to the same embodiment. In addition, some features, structures or characteristics in one or more embodiments of the present application can be appropriately combined.

Similarly, it should be noted that in order to simplify the description of the disclosure of this application and thus help understand one or more application embodiments, in the above description of the embodiments of this application, multiple features are sometimes merged into one embodiment, figure or description thereof. However, this disclosure method does not mean that the features required by the object of this application are more than the features mentioned in the claims. In fact, the features of the embodiments are less than all the features of the single embodiment disclosed above.

In some embodiments, the numbers describing the number of components and attributes are used. It should be understood that such numbers used for the description of the embodiments are modified by the modifiers "about", "approximately" or "substantially" in some examples. Unless otherwise specified, "about", "approximately" or "substantially" indicate that the numbers allow a change of ± 20%. Accordingly, in some embodiments, the numerical parameters used in the specification and claims are approximate values, which can be changed according to the required characteristics of the individual embodiments. In some embodiments, the numerical parameters should consider the specified significant digits and adopt the method of general digit retention. Although the numerical domains and parameters used to confirm the breadth of the range in some embodiments of the present application are approximate values, in a specific embodiment, the setting of such numerical values is as accurate as possible within the feasible range.

Although the present application has been described with reference to the current specific embodiments, ordinary technicians in this technical field should recognize that the above embodiments are only used to illustrate the present application, and various equivalent changes or substitutions may be made without departing from the spirit of the present application. Therefore, as long as the changes and modifications to the above embodiments are within the essential spirit of the present application, they will fall within the scope of the claims of the present application.

## Claims

1. A back-contact cell, **characterized by** comprising:
a silicon substrate, wherein the silicon substrate comprises a substrate front side close to sunlight and a substrate back side away from the sunlight;
a first doping region, an isolation region, and a second doping region located on the substrate back side, wherein the first doping region and the second doping region have different doping elements, and the isolation region is located between the first doping region and the second doping region on the substrate back side;
a front passivation anti-reflection layer located on the substrate front side; and
a protective layer located on at least a portion of the front passivation anti-reflection layer, wherein the protective layer comprises resin material.

2. The back-contact cell according to claim 1, **characterized by** further comprising a cell edge and an edge protection area, wherein the protective layer is located in the edge protection area, and an outer side of the edge protection area closer to the cell edge is 0.1 mm~10 mm away from the cell edge.

3. The back-contact cell according to claim 2, **characterized in that** a width of the edge protection area is 0.005mm~10mm.

4. The back-contact cell according to claim 1, **characterized in that** the protective layer has a pyramid texture.

5. The back-contact cell according to claim 4, **characterized in that** the protective layer is formed by roller embossing, wherein a surface of the roller has pyramid-shaped protrusions.

6. The back-contact cell according to claim 5, **characterized in that** the protective layer is formed by attaching a protective agent on at least a portion of the front passivation anti-reflection layer, performing a first curing, using roller embossing, and performing a second curing, wherein a first curing time of the first curing is shorter than a second curing time of the second curing.

7. The back-contact cell according to claim 6, **characterized in that** an irradiation energy of the first curing and/or the second curing is 1300mj/cm² ~ 1700mj /cm².

8. The back-contact cell according to claim 4, **characterized in that** the protective layer is formed by spraying a protective agent, wherein the spraying includes spraying the protective agent in shape of ink drops on at least a portion of the front passivation anti-reflection layer to form the protective layer having the pyramid texture on the front passivation anti-reflection layer.

9. The back-contact cell according to claim 4, **characterized in that** the protective layer is formed by printing a protective agent through a screen printing, wherein a screen mold of the screen printing has a pyramid shape, and the screen printing includes printing the protective agent on at least a portion of the front passivation anti-reflection layer through the screen mold to form the protective layer having the pyramid texture on the front passivation anti-reflection layer.

10. The back-contact cell according to any one of claims 1~9, **characterized in that** the silicon substrate is N-type substrate or P-type substrate.

11. The back-contact cell according to any one of claims 1~9, **characterized in that** the substrate front side is a suede surface, and a side of the front passivation anti-reflection layer away from the substrate front side is also the suede surface.

12. The back-contact cell according to any one of claims 1~9, **characterized in that** the front passivation anti-reflection layer comprises aluminum oxide, silicon nitride and/or silicon oxynitride.

13. The back-contact cell according to any one of claims 1~9, **characterized by** further comprising a back passivation anti-reflection layer located on a side of the first doping region, the isolation region, and the second doping region away from the substrate back side, and the back passivation anti-reflection layer includes aluminum oxide and/or silicon nitride.

14. The back-contact cell according to claim 13, **characterized by** further comprising a first electrode and a second electrode located on side of the substrate back side, wherein the first electrode and the second electrode pass through the back passivation anti-reflection layer and contact the first doping region and the second doping region respectively.

15. The back-contact cell according to any one of claims 1~9, **characterized in that** the protective layer covers 1%~50% of the substrate front side.

16. The back-contact cell according to claim 15, **characterized in that** the protective layer is in a continuous or discontinuous straight-line shape or an irregular shape on the substrate front side.

17. The back-contact cell according to any one of claims 1~9, **characterized in that** a thickness of the protective layer along a first direction perpendicular to the silicon substrate is 6µm~15µm.

18. The back-contact cell according to any one of claims 1~9, **characterized in that** a transmittance of the protective layer for incident light in a wavelength range of 300 nm~1200 nm is greater than 80%.

19. The back-contact cell according to any one of claims 1~9, **characterized in that** a refractive index of the protective layer is less than 1.6.

20. The back-contact cell according to any one of claims 1~9, **characterized in that** the resin material comprises epoxy resin or acrylic resin.

21. A back-contact cell module, **characterized by** comprising a plurality of back-contact cells according to any one of claims 1~20 stacked on each other.
